# EUROPEAN PATENT SPECIFICATION

(11) **EP 1 617 714 B1**
(45) Date of publication and mention of the grant of the patent: **10.09.2008**
(21) Application number: 04291824.3
(22) Date of filing: 16.07.2004
(51) Int. Cl.: H05K 1/18, H01L 25/10, H05K 7/02

(54) **Electronic circuit assembly, device comprising such assembly and method for fabricating such device**
Elektronische Schaltungsanordnung, Vorrichtung mit solcher Anordnung und Herstellungsverfahren
Ensemble électronique, dispositif comportant un tel ensemble et procédé de fabrication

(43) Date of publication of application: 18.01.2006
(73) Proprietor: STMicroelectronics S.A., 92120 Montrouge (FR); Imbera Electronics Oy, 02150 Espoo (FI)
(72) Inventor: Baraton, Xavier, 92120 Montrouge (FR); Cognetti, Carlo, 20149 Milano (IT); Tuominen, Risto, 02150 Espoo (FI)
(74) Representative: Verdure, Stéphane

(56) References cited:
- EP-A- 0 802 566
- DE-A- 10 207 308
- US-A- 4 956 694
- US-A- 5 956 233
- US-A1- 2002 147 263
- US-B1- 6 359 235

## Description

The invention relates to an electronic circuit assembly and to a device comprising such assembly. It further relates to a method for fabricating such device.

The general trend for reducing the size of electronic devices leads to stack several dice one upon another within a device. The base surface of such device is thus limited in size while more complex functions can be achieved by the device.

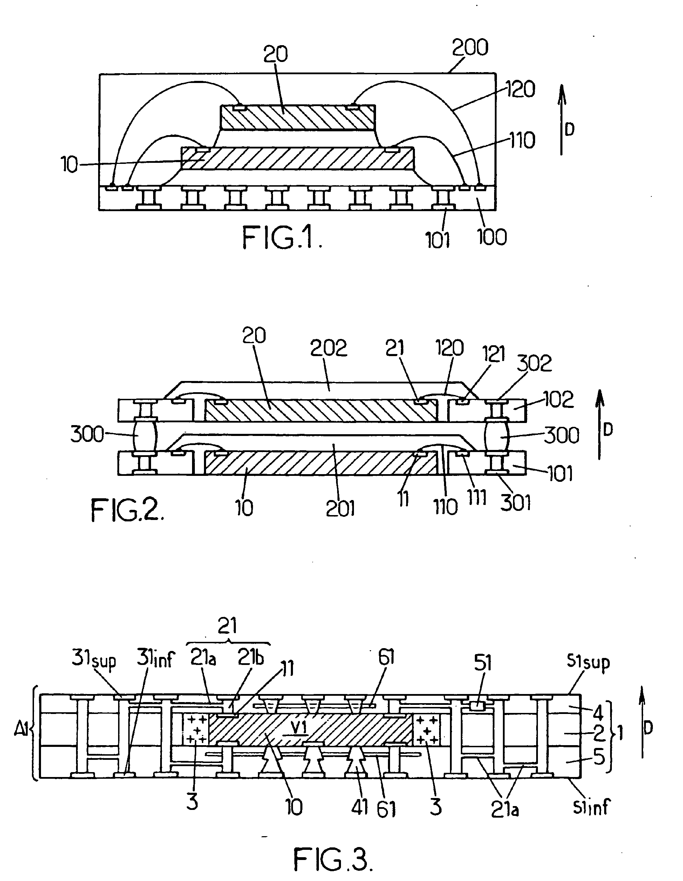

Several technologies have been developed for electrically connecting dice that are stacked within a single device. Figures 1 and 2 illustrate two existing technologies.

According to Figure 1, at least two dice 10, 20 are stacked within a single circuit package. The dice 10, 20 are arranged so that respective main faces of the dice are perpendicular to the stacking direction D. The die 20 is fixed onto the die 10 with appropriate gluing means. The circuit package comprises a base element 100 for supporting the die stack and a cap 200 for enclosing the dice. Each die 10, 20 is electrically connected to pads arranged in the base element 100, around a portion of the base element 100 located beneath the stack. Wirebonding 110, 120 is used for these connexions, and a resin of the cap 200 is cast over the stack and the wires for protection and mechanical strengthening purposes.

A drawback of such die stacking technology results from the assembly steps that are necessary. Indeed, it involves numerous and complex steps comprising die fixing, wirebonding and moulding. Furthermore, when successive dice in the stack have substantially same sizes, an interposer must be arranged therebetween, so that connecting wires can be arranged on the upper face of the lower die. The total height of the stack is thus increased, which limits the capacity of the device to be integrated.

Another drawback of such die stacking technology results from the device operating tests which can be carried out only after the whole assembly is completed. It is so because the electrical terminals 101 in the base element 100 are necessary for connecting the circuits to a testing head. Then a yield loss has an important cost impact, because of the number of dice in the stack and because of the number of assembling steps per stack.

Alternatively, the so-called "flip-chip" process may be used for stacking dice one upon another. According to said flip-chip process, which is well known per se, solder bumps are arranged between matching terminals located on respective outer faces of two dice. But the flip-chip process must be combined with wirebonding for a same stack, because it is limited for connecting die terminals that are facing one another.

Figure 2 illustrates another technology called "substrate stacking". In this case, each die 10, 20 is fixed onto a respective substrate 101, 102. The substrates 101, 102 are fixed one upon another with solder balls 300 arranged between respective pads 301, 302 located in peripheral portions of each substrate. Each die 10, 20 may be laid on an upper surface of the corresponding substrate 101, 102 or inserted into an opening of the substrate. Electrical connexions 110, 120 using wirebonding process extend between terminals of each die 10, 20 and electrically conducting elements 111, 121 arranged in the corresponding substrate 101, 102. For protection purpose, each assembly of a die together with the corresponding substrate further comprises a resin cap 201, 202 moulded over the die and a part of the substrate.

Alternatively, each die can be fixed on and electrically connected to the corresponding substrate using the flip-chip process. Then, the substrate extends beneath the die and solder bumps arranged at points of an array connect terminals of the die to pads of the substrate. A resin portion may fill in the gap between the die and the substrate around each bump.

According to the substrate stacking technology, the solder balls 300 have two functions. First, they hold together the successive substrates 101, 102 of the stack. Besides, they form electrical connexions between the substrates 101, 102. As the solder balls 300 can only be arranged on each substrate in a peripheral portion surrounding the die, the number of inter-substrate connexions thus obtained may be insufficient in respect of the electrical design of the whole device.

Furthermore, in both the die stacking and the substrate stacking technologies described hereabove, the number of electrical connexions connecting each die is limited when wirebonding is used. Indeed, in the case of die stacking, electrical connexions between a die and the base element of the package can only be arranged near the peripheral edge of the die. The same limitation applies for substrate stacking combined with wirebonding.

Other examples of electronic circuit assemblies are known from documents DE-A-102 07 308, US-A-5 956 233 and US-B-6 359 235.

It is therefore an object of the present invention to provide an electronic circuit design allowing stacking with a greater number of electrical connexions.

The invention thus proposes an electronic circuit assembly comprising :
- a casing having two opposite outer faces and an inner space separate from each of said outer faces by a respective closing portion,
- first and second sets of pads each located on a respective one of said outer faces of the casing, and
- a die incorporating an integrated circuit and electrical terminals, said die being affixed to the casing within said inner space.

The casing includes integrated electrically conducting elements connecting terminals of the die to pads of the casing, and connecting pads of said first set of pads to pads of said second set of pads. Furthermore, each one of said first and second sets of pads is arranged for making it possible to connect said electronic circuit assembly to respective other electronic circuit assemblies with a pad mirror-matching relationship.

An electronic circuit assembly according to the invention is suitable for being stacked with other electronic circuit assemblies thanks to the pads located on the outer faces of the casing and the electrically conducting elements connecting these pads. Indeed, electrical connexions can thus be achieved between several electronic circuit assemblies stacked one on another.

Thanks to the closing portions of the casing provided on both sides of the die, it is possible, in an assembly according to the invention, to connect terminals of the die located in a middle part of the die, and not only located near an edge of the die. Therefore, the die can be provided with a great number of electrical connexions, by arranging as many terminals as necessary on at least one whole face of the die.

Several electronic circuit assemblies according to the invention can be stacked one on another, in a manner similar to the substrate stacking technology previously described. But connexions between two successive assemblies in the stack can be arranged with pads located on the whole surface of each casing face, so that a great number of inter-casing connexions can be achieved. In particular, at least one pad can be supported by one of said closing portions of the casing.

Advantageously, pads of at least one of said first and second sets of pads can be arranged in array, on the corresponding outer face of the casing. Then the mirror-matching relationship between the sets of pads of two successively stacked electronic circuit assemblies can easily be achieved.

Consequently, the invention is an improvement of the substrate stacking technology for at least two reasons. First, the number of die connexions can be increased, as well as the number of inter-casing connexions. Second, no wirebonding is necessary for connecting dies, so that the circuit assembly obtained is particularly strong.

Another advantage of a device according to the invention results from the providing of pads on the casing. Indeed, thanks to these pads, the electronic circuit assembly can be connected to a testing head before it is further connected to other electronic circuit assemblies or whatever external electrical circuit. Then, in case of malfunctioning of the die or in case of any defect in the assembly, the electronic circuit assembly can be discarded without impairing any other assembly or external circuit. The cost impact due to such malfunctioning or defect is then limited.

According to a preferred embodiment of the invention, the opposite outer faces of the assembly casing are substantially parallel one to the other. Then, two other electronic circuit assemblies respectively connected on each side of the casing are in a parallel orientation relationship, so that the assembly stack has a general outer shape which is simple and compatible with many packaging designs.

Advantageously, the pads of the casing are designed for ball soldering. Then a currently available ball soldering process can be used for connecting two electronic circuit assemblies one to the other.

The invention also proposes a device comprising at least one such electronic circuit assembly. In particular, the device may comprise several electronic circuit assemblies stacked along a stacking direction substantially perpendicular to the respective casing opposite outer faces of said assemblies. Two successive assemblies along said stacking direction are connected one to the other via bonding means connecting respective sets of pads of said successive assemblies.

Advantageously, the connected respective pads of two successive assemblies in the stack are facing one another. Then, the respective pad sets of the two electronic circuit assemblies are in a mirror relationship, so that a face to face connecting process can be used.

Finally, the invention proposes a method for fabricating a device comprising the following steps :
a- obtaining a first electronic circuit assembly of the type previously described ;
b- obtaining a second electronic circuit assembly having a respective set of pads arranged on an outer face of said second assembly in mirror-matching relationship with a first one of the sets of pads of said first assembly;
c- obtaining a third electronic circuit assembly having a respective set of pads arranged on an outer face of said third assembly in mirror-matching relationship with a second one of the sets of pads of said first assembly;
d- connecting said second electronic circuit assembly to said first electronic circuit assembly by arranging a first set of bounding means between pads of said second assembly and pads of said first set of pads of said first assembly ; and
e- connecting said third electronic circuit assembly to said first electronic circuit assembly by arranging a second set of bounding means between pads of said third assembly and pads of said second set of pads of said first assembly.

Said second electronic circuit assembly may comprise a base element of the device. Then the device can be easily incorporated into an apparatus without any useless gap between the device and the apparatus. Therefore, the apparatus may be small-sized, which is especially required for apparatuses such as mobile communication terminals, as for an example.

Said third electronic circuit assembly may be provided with another set of pads opposite to said outer face of said third assembly and arranged for connecting said third assembly to a fourth electronic circuit assembly having a respective set of pads in mirror-matching relationship with said another set of pads of said third assembly.

These and other aspects of the invention will become apparent from the non-limiting embodiments described hereafter in reference to the following drawings :
- Figure 1 is a sectional view of a die stack according to a first technology known from prior art ;
- Figure 2 is a sectional view of a stack of die substrates according to a second technology known from prior art ;
- Figure 3 is a sectional view of an assembly according to the invention ; and
- Figure 4 is a sectional view of an assembly stack according to the invention.

Through the figures, same reference numbers refer to similar elements, or to elements having similar functions. Furthermore, for sake of clarity, the sizes of the elements represented do not correspond to actual sizes of said elements.

All these figures represent at least one die which has main faces oriented horizontally and perpendicular to the plane of the figures. Letter D denotes a direction oriented upwards, and words like "on", "under", "upper" and "lower" used hereinafter are used in consideration of the direction D.

Figures 1 and 2 have already been described previously.

Referring to Figure 3, a casing element 2 has two opposite outer faces, namely an upper face and a lower face. Said faces are parallel one to the other, and oriented perpendicular to the direction D. The casing element 2 is provided with an empty space V1 in a central part of it. The space V1 is open upwards and downwards. The overall dimensions of the casing element 2 in a plane perpendicular to the direction D may be 8 millimeters x 8 millimeters, and the inner dimensions of the space V1 in the same plane may be 4 millimeters x 4 millimeters. A die 10 is affixed to the casing element 2, within the space V1, with a glue or resin portion 3 arranged between the die 10 and the casing element 2. Therefore, the casing element 2 surrounds the die 10 in a plane perpendicular to the direction D.

One possible method for assembling the die 10 into the casing element 2 is to provide initially the casing element 2 with a bottom plate (not represented) closing the space V1 downwards. The bottom plate is perpendicular to the direction D and may be about 40 micrometers thick. Then the die 10 is introduced into the space V1 from the upper side of the casing element 2, until it is supported by the bottom plate. The lateral gap between the die 10 and the casing element 2 is filled with glue or resin, and then the bottom plate is eliminated, for example by polishing.

The die 10 is of common type with an electronical circuit integrated. It is provided with electrical terminals 11 on at least one face, for example the upper face of the die 10. The die 10 may be 3 millimeters x 3 millimeters in a plane perpendicular to the direction D, and 80 micrometers thick along the direction D.

Optionally, the upper and lower faces of the joined casing element 2 and die 10 may be polished so that continuous and planar surfaces extend over the casing element 2 and the die 10 on the upper and lower sides.

Then, in a known manner, a layer 4 is applied on the upper face of the joined casing element 2 and die 10. The layer 4 incorporates pads 31ₛᵤₚ arranged on its upper face S1ₛᵤₚ, and electrically conducting elements 21 that connect terminals 11 of the die 10 to some of the pads 31ₛᵤₚ. Layer 4 may consist in several sub-layers (not represented) stacked one on another along the direction D, so that it is laminated. The sub-layers are alternatively made of electrically insulating or conducting materials, such as a synthetic material or copper. These sub-layers may be applied as continuous films and then etched for obtaining the conducting elements in the form of tracks 21 a and vias 21 b, respectively substantially parallel to and perpendicular to the outer face S1ₛᵤₚ.

A layer 5 similar to layer 4 is applied on the lower face of the joined casing element 2 and die 10. Similarly, layer 5 incorporates pads 31_{inf} arranged on its lower face S1_{inf} and additional electrically conducting elements. As for an example of variations that can be introduced in the device, layer 4 is represented at Figure 3 with a single level of tracks 21 a, whereas layer 5 is represented with two different levels of tracks.

Electrical connexions are also arranged through the casing element 2 for connecting some of the pads 31ₛᵤₚ to some of the pads 31_{inf}.

The casing element 2, together with layers 4 and 5, constitute the casing 1. Layers 4 and 5 constitute closing portions of the casing 1 located between the space V1 and the outer surfaces of the casing, S1ₛᵤₚ or S1_{inf} respectively. The height of the whole casing 1 may be less than 250 micrometers, along direction D. The die 10 is therefore embedded in the casing 1 and electrically connected to pads arranged on either side of the casing 1 via the elements 21. The casing 1 and the die 10 constitute the electronic circuit assembly A1. It is specified that the invention is not limited to the fabrication method of the assembly A1 just described, but that it may be combined with any fabrication method suitable for obtaining a similar assembly.

The pads 31ₛᵤₚ and 31_{inf} may be arranged at points of a BGA (standing for "ball grid array") on each outer face S1ₛᵤₚ, S1_{inf} of the casing 1. Then, the layout of the pads is simple and compatible with design rules that are common in the art. Some of the pads 31ₛᵤₚ, 31_{inf} may be located on one of the closing portions of the casing 1. In particular, a respective pad array may extend continuously on each of the face S1ₛᵤₚ, S1_{inf}. Then a great number of pads can be arranged on the casing 1, suitable with complex circuits which require numerous electrical connexions.

Optionally, the assembly A1 further comprises at least one thermally conducting element 41 extending from a portion of the casing 1 close to the die 10 to at least one pad 31ₛᵤₚ, 31_{inf}. Such thermally conducting element 41 is useful for dissipating heat produced in the die 10 under operation. The pad used for the thermally conducting element 41 may be arranged on one of the outer faces S1ₛᵤₚ, S1_{inf} in a similar way than the pads used for the electrically conducting elements 21. Furthermore, the pads for thermally conducting elements 41 and the pads for electrically conducting elements 21 can be located on each outer face S1ₛᵤₚ, S1_{inf} of the casing 1 at different respective points of a same BGA. For better heat dissipation, the thermally conducting element 41 may extend substantially perpendicular to the outer face of the casing 1 corresponding to the pad it connects. Advantageously, it is provided within the layers 4 and/or 5 in the form of a via. This via may be electrically insulated from the die 10.

In one embodiment, the assembly A1 further comprises at least one electronic component 51 integrated in the casing 1. Such component 51 may be a resistor, a capacitor, a coil, or any other passive or active component. Thus a high integration level can be achieved, combining, within the casing 1, electrical components integrated within the die 10 and other components arranged outside this die. According to a preferred embodiment, the component 51 may be integrated within the layer 4 and/or 5.

In one embodiment, the assembly A1 further comprises at least one radiation shield 61 arranged in the layers 4 or 5 for stopping electromagnetic radiations produced in the die 10 under operation. Such shield may be a portion of a metal sub-layer, for example of copper, oriented parallel to the outer faces S1ₛᵤₚ, S1_{inf}. It is useful when the radiations produced by the circuit incorporated in the die 10 may disturb any other circuit external to the die 10, for example a circuit incorporated in another assembly connected to the assembly A1.

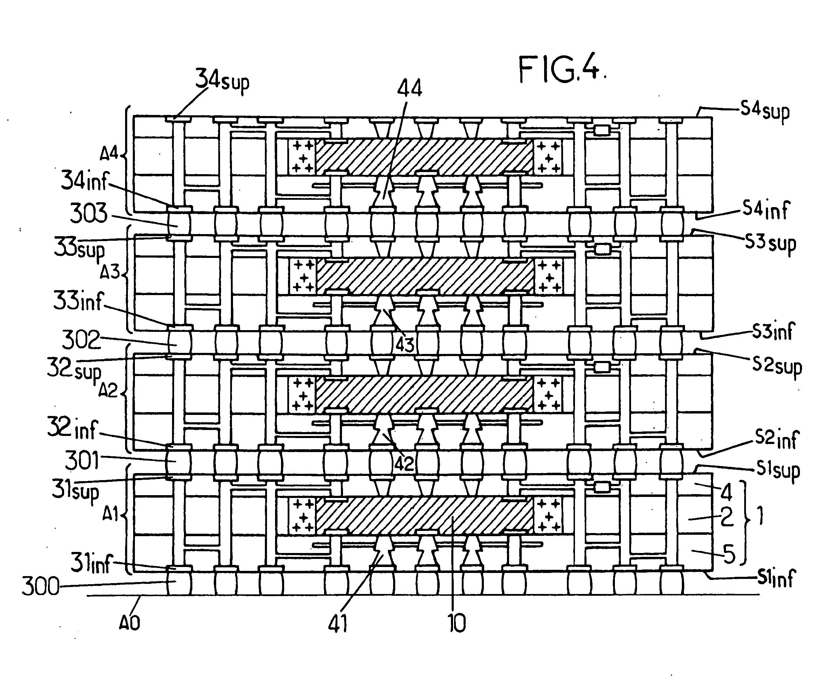

According to Figure 4, several electronic circuit assemblies similar to the assembly just described (referenced A1-A4 for example) are connected on their respective opposite outer faces (Snₛᵤₚ, Sn_{inf} for assembly An, n being an integer from 1 to 4) to form a stack. Advantageously, the respective opposite outer faces of the casing of each electronic circuit assembly are substantially parallel one to the other. Then, the stack extends parallel to the direction D, so that the stack is compact and can be produced with production equipments that are less complex.

The mutually connected pads of two successive assemblies in the stack are facing one another. Furthermore, the pads of each casing (referenced 3nₛᵤₚ and 3n_{inf} for assembly An) may be designed for ball soldering. Then, the bonding means 301-303 arranged between the pads of successive assemblies in the stack may comprise solder balls. Production ball-soldering equipments that are commercially available can thus be used. The pads for the thermally conducting elements in each assembly (referenced 4n for the assembly An) may be connected one to the other in a manner similar to the pads for the electrically conducting elements. Hence, continuous paths for dissipating heat are arranged through the whole stack along the direction D, so that the maximum temperature reached in the device under operation is limited.

Furthermore, the assembly A1 may be connected on its lower outer face S1_{inf} to a base element A0. In respect to the connexion of the assembly A1, the base element A0 can be considered in a similar manner as the assembly A2.

It shall be understood that many changes may be introduced in the method for fabricating stacked device that has been just described. In particular, the layout of the electrically or thermally conducting elements within the casing, as well as the corresponding pads, may be varied. Furthermore, these conducting elements and pads may be produced using basic process steps different from those cited.

## Claims

1. Electronic circuit assembly (A1) comprising :
- a casing (1) having two opposite outer faces (S1ₛᵤₚ, S1_{Inf}) and an inner space (V1) separate from each of said outer faces by a respective closing portion (4, 5),
- first and second sets of pads (31ₛᵤₚ, 31_{Inf}) each located on a respective one of said outer faces of the casing (1), and
- a die (10) incorporating an integrated circuit and electrical terminals (11), said die (10) being affixed to the casing (1) within said inner space (V1),
wherein the casing (1) includes integrated electrically conducting elements (21) connecting terminals of the die (11) to pads of the casing (31ₛᵤₚ), and connecting pads of said first set of pads (31ₛᵤₚ) to pads of said second set of pads (31_{Inf}),
and wherein each one of said first and second sets of pads (31ₛᵤₚ, 31_{Inf}) is arranged for making it possible to connect said electronic circuit assembly (A1) to respective other electronic circuit assemblies with a pad mirror-matching relationship,
the assembly being **characterized in that** only one single die is arranged within the casing, and **in that** the die (10) has two sets of electrical terminals on respective faces of said die.

2. Electronic circuit assembly according to Claim 1, wherein at least one pad (31ₛᵤₚ, 31_{Inf}) is supported by one of said closing portions of the casing (4, 5).

3. Electronic circuit assembly according to Claims 1 or 2, wherein the pads of at least one of said first and second sets of pads (31ₛᵤₚ, 31_{Inf}) are arranged in array.

4. Electronic circuit assembly according to any one of the preceding claims, wherein said opposite outer faces of the casing (S1ₛᵤₚ, S1_{Inf}) are substantially parallel one to the other.

5. Electronic circuit assembly according to any one of the preceding claims, wherein the pads (31ₛᵤₚ, 31_{Inf}) are designed for ball soldering.

6. Electronic circuit assembly according to any one of the preceding claims, further comprising at least one thermally conducting element (41) extending from a portion of the casing (1) close to the die (10) to at least one pad (31ₛᵤₚ, 31_{inf}).

7. Electronic circuit assembly according to Claim 6, wherein said thermally conducting element (41) extends substantially perpendicular to the outer face of the casing corresponding to said at least one pad (31ₛᵤₚ, 31_{inf}).

8. Electronic circuit assembly according to any one of the preceding claims, further comprising at least one electronic component (51) integrated in the casing (1).

9. Electronic circuit assembly according to any one of the preceding claims, wherein said die (10) is a memory die.

10. Electronic circuit assembly according to any one of the preceding claims, wherein each one of the two closing portions of the casing (4, 5) has electrical terminals arranged on respective inner faces of said closing portions.

11. Device comprising at least one electronic circuit assembly (A1-A4) according to any one of the preceding claims.

12. Device according to Claim 11, comprising several electronic circuit assemblies (A1-A4) stacked along a stacking direction (D) substantially perpendicular to the respective casing opposite outer faces of said assemblies (S1ₛᵤₚ-S4ₛᵤₚ, S1_{inf}-S4_{inf}), wherein two successive assemblies along said stacking direction are connected one to the other via bonding means (300-303) connecting respective sets of pads of said successive assemblies (31ₛᵤₚ-34ₛᵤₚ, 31_{inf}-34_{inf}).

13. Device according to Claim 12, wherein the connected respective pads of two successive assemblies In the stack (31ₛᵤₚ, 32_{inf}) are facing one another.

14. Device according to Claim 13, wherein the bonding means (300-303) comprise solder balls.

15. Method for fabricating an electronic device comprising the following steps :
a- obtaining a first electronic circuit assembly (A1) according to any one of the claims 1 to 10 ;
b- obtaining a second electronic circuit assembly (A0) having a respective set of pads arranged on an outer face of said second assembly in mirror-matching relationship with a first one of the sets of pads of said first assembly (31_{inf}) ;
c- obtaining a third electronic circuit assembly (A2) having a respective set of pads (32_{inf}) arranged on an outer face of said third assembly (S2_{inf}) In mirror-matching relationship with a second one of the sets of pads of said first assembly (31ₛᵤₚ) ;
d- connecting said second electronic circuit assembly (A0) to said first electronic circuit assembly (A1) by arranging a first set of bounding means (300) between pads of said second assembly and pads of said first set of pads of said first assembly (31_{inf}) ; and
e- connecting said third electronic circuit assembly (A2) to said first electronic circuit assembly (A1) by arranging a second set of bounding means (301) between pads of said third assembly and pads of said second set of pads of said first assembly (31ₛᵤₚ).

16. Method according to Claim 15, wherein the bonding means (300, 301) comprise solder balls.

17. Method according to Claim 15 or 16, wherein said second electronic circuit assembly (A0) comprises a base element of the device.

18. Method according to any one of claims 15 to 17, wherein said third electronic circuit assembly (A2) Is provided with another set of pads (32ₛᵤₚ) opposite to said outer face of said third assembly (S2_{inf}) and arranged for connecting said third assembly (A2) to a fourth electronic circuit assembly (A3) having a respective set of pads (33_{inf}) in mirror-matching relationship with said another set of pads of said third assembly (32ₛᵤₚ).

## Patentansprüche

1. Elektronische Schaltungsanordnung (A1), umfassend:
- ein Gehäuse (1), welches zwei gegenüberliegende äußere Flächen (S1ₛᵤₚ, S1_{inf}) aufweist, und einen inneren Raum (V1), getrennt von jeder der äußeren Flächen durch einen jeweiligen abschließenden Abschnitt (4, 5),
- einen ersten und einen zweiten Satz von Pads (31ₛᵤₚ, 31_{inf}), wobei sich jeder an einer jeweiligen der äußeren Flächen des Gehäuses (1) befindet, und
- einen Chip (10), welcher eine integrierte Schaltung und elektrische Anschlüsse (11) enthält, wobei der Chip (10) an dem Gehäuse (1), innerhalb des inneren Raums (V1), befestigt ist,
wobei das Gehäuse (1) integrierte elektrisch leitende Elemente (21) aufweist, welche Anschlüsse des Chips (11) mit Pads des Gehäuses (31ₛᵤₚ) verbinden, und welche Pads des ersten Satzes von Pads (31ₛᵤₚ) mit Pads des zweiten Satzes von Pads (31_{inf}) verbinden,
und wobei jeder des ersten und zweiten Satzes von Pads (31ₛᵤₚ, 31_{inf}) angeordnet ist, um es möglich zu machen, die elektronische Schaltungsanordnung (A1) mit jeweiligen anderen elektronischen Schaltungsanordnungen, bei einer gespiegelt zusammenpassenden Beziehung der Pads, zu verbinden,
wobei die Anordnung **dadurch gekennzeichnet ist, dass** nur ein einziger Chip innerhalb des Gehäuses angeordnet ist, und **dadurch**, dass der Chip (10) zwei Sätze elektrischer Anschlüsse an jeweiligen Flächen des Chips aufweist.

2. Elektronische Schaltungsanordnung nach Anspruch 1, wobei wenigstens ein Pad (31ₛᵤₚ, 31_{inf}) von einem der abschließenden Abschnitte (4, 5) des Gehäuses getragen ist.

3. Elektronische Schaltungsanordnung nach Anspruch 1 oder 2, wobei die Pads von wenigstens einem des ersten und zweiten Satzes von Pads (31ₛᵤₚ, 31_{inf}) als Array angeordnet sind.

4. Elektronische Schaltungsanordnung nach einem der vorhergehenden Ansprüche, wobei die gegenüberliegenden äußeren Flächen des Gehäuses (S1ₛᵤₚ, S1_{inf}) im Wesentlichen zueinander parallel sind.

5. Elektronische Schaltungsanordnung nach einem der vorhergehenden Ansprüche, wobei die Pads (31ₛᵤₚ, 31_{inf}) zum Löten mit Kugeln gestaltet sind.

6. Elektronische Schaltungsanordnung nach einem der vorhergehenden Ansprüche, ferner umfassend wenigstens ein wärmeleitendes Element (41), welches sich, von einem Abschnitt des Gehäuses (1) aus, nahe dem Chip (10), zu wenigstens einem Pad (31ₛᵤₚ, 31_{inf}) erstreckt.

7. Elektronische Schaltungsanordnung nach Anspruch 6, wobei sich das wärmeleitende Element (41) im Wesentlichen rechtwinkelig zu der äußeren Fläche des Gehäuses, entsprechend dem wenigstens einen Pad (31ₛᵤₚ, 31_{inf}), erstreckt.

8. Elektronische Schaltungsanordnung nach einem der vorhergehenden Ansprüche, ferner umfassend wenigstens ein elektronisches Bauelement (51), welches in dem Gehäuse (1) integriert ist.

9. Elektronische Schaltungsanordnung nach einem der vorhergehenden Ansprüche, wobei der Chip (10) ein Speicherchip ist.

10. Elektronische Schaltungsanordnung nach einem der vorhergehenden Ansprüche, wobei jeder der zwei abschließenden Abschnitte (4, 5) des Gehäuses elektrische Anschlüsse aufweist, welche an einer jeweiligen inneren Fläche der abschließenden Abschnitte angeordnet sind.

11. Vorrichtung, umfassend wenigstens eine elektronische Schaltungsanordnung (A1 bis A4), nach einem der vorhergehenden Ansprüche.

12. Vorrichtung nach Anspruch 11, umfassend mehrere elektronische Schaltungsanordnungen (A1 bis A4), welche entlang einer Stapelrichtung (D) gestapelt sind, im Wesentlichen rechtwinkelig zu den jeweiligen gegenüberliegenden äußeren Gehäuseflächen (S1ₛᵤₚ bis S4ₛᵤₚ, S1_{inf} bis S4_{inf}) der Anordnungen, wobei zwei aufeinander folgende Anordnungen, entlang der Stapelrichtung, miteinander über Bondmittel (300 bis 303) verbunden sind, welche jeweilige Sätze von Pads (31ₛᵤₚ bis 34ₛᵤₚ, 31_{inf} bis 34_{inf}) der aufeinander folgenden Anordnungen miteinander verbinden.

13. Vorrichtung nach Anspruch 12, wobei die jeweiligen verbundenen Pads (31ₛᵤₚ, 32_{inf}) zweier aufeinander folgender Anordnungen in dem Stapel einander zugewandt sind.

14. Vorrichtung nach Anspruch 13, wobei die Bondmittel (300 bis 303) Lotkugeln umfassen.

15. Verfahren zum Herstellen einer elektronischen Vorrichtung, umfassend die folgenden Schritte:
a - Schaffen einer ersten elektronischen Schaltungsanordnung (A1), nach einem der Ansprüche 1 bis 10;
b - Schaffen einer zweiten elektronischen Schaltungsanordnung (A0), welche einen jeweiligen Satz von Pads aufweist, welcher an einer äußeren Fläche der zweiten Anordnung, in gespiegelt zusammenpassender Beziehung mit einem ersten der Sätze von Pads (31_{inf}) der ersten Anordnung, angeordnet ist;
c - Schaffen einer dritten elektronischen Schaltungsanordnung (A2), welche einen jeweiligen Satz von Pads (32_{inf}) aufweist, welcher an einer äußeren Fläche (S2_{inf}) der dritten Anordnung, in gespiegelt zusammenpassender Beziehung mit einem zweiten der Sätze von Pads (31ₛᵤₚ) der ersten Anordnung, angeordnet ist;
d - Verbinden der zweiten elektronischen Schaltungsanordnung (A0) mit der ersten elektronischen Schaltungsanordnung (A1) durch Anordnen eines ersten Satzes von Bondmitteln (300) zwischen Pads der zweiten Anordnung und Pads des ersten Satzes von Pads (31_{inf}) der ersten Anordnung; und
e - Verbinden der dritten elektronischen Schaltungsanordnung (A2) mit der ersten elektronischen Schaltungsanordnung (A1) durch Anordnen eines zweiten Satzes von Bondmitteln (301) zwischen Pads der dritten Anordnung und Pads des zweiten Satzes von Pads (31ₛᵤₚ) der ersten Anordnung.

16. Verfahren nach Anspruch 15, wobei die Bondmittel (300, 301) Lotkugeln umfassen.

17. Verfahren nach Anspruch 15 oder 16, wobei die zweite elektronische Schaltungsanordnung (A0) ein Basiselement der Vorrichtung umfasst.

18. Verfahren nach einem der Ansprüche 15 bis 17, wobei die dritte elektronische Schaltungsanordnung (A2) mit einem weiteren Satz von Pads (32ₛᵤₚ) versehen ist, welcher der äußeren Fläche (S2_{inf}) der dritten Anordnung gegenüberliegt, und angeordnet ist, zum Verbinden der dritten Anordnung (A2) mit einer vierten elektronischen Schaltungsanordnung (A3), welche einen jeweiligen Satz von Pads (33_{inf}), in gespiegelt zusammenpassender Beziehung mit dem weiteren Satz von Pads (32ₛᵤₚ) der dritten Anordnung, aufweist.

## Revendications

1. Ensemble de circuit électronique (A1) comprenant :
- un boîtier (1) ayant deux faces extérieures opposées (S1ₛᵤₚ, S1_{inf}) et un espace intérieur (V1) séparé de chacune desdites faces extérieures par une portion de fermeture respective (4, 5),
- des premiers deuxièmes groupes de pastilles (31ₛᵤₚ, 31_{inf}) chacun situé sur l'une respective desdites faces extérieures du boîtier (1), et
- une microplaquette (10) incorporant un circuit intégré et des bornes électriques (11), ladite microplaquette (10) étant fixée au boîtier (1) à l'intérieur dudit espace intérieur (V1),
dans lequel le boîtier (1) comprend des éléments électriquement conducteurs intégrés (21) connectant des bornes de la microplaquette (1) à des pastilles du boîtier (31ₛᵤₚ) et connectant des pastilles dudit premier groupe de pastilles (31ₛᵤₚ) à des pastilles dudit deuxième groupe de pastilles (31_{inf}),
et dans lequel chacun desdits premier et deuxième groupe de pastilles (31ₛᵤₚ, 31_{inf}) est agencé pour rendre possible une connexion dudit ensemble de circuit électronique (A1) à d'autres ensembles de circuit électronique respectifs avec une relation de correspondance par symétrie-miroir,
l'ensemble étant **caractérisé en ce que** seulement une unique microplaquette est agencée à l'intérieur du boîtier et **en ce que** la microplaquette (10) a deux groupes de bornes électriques sur des faces respectives de ladite microplaquette.

2. Ensemble de circuit électronique selon la revendication 1, dans lequel au moins une pastille (31ₛᵤₚ, 31_{inf}) est supportée par une desdites portions de fermeture du boîtier (4, 5).

3. Ensemble de circuit électronique selon la revendication 1 ou 2, dans lequel les pastilles d'au moins un desdits premier et deuxième groupe de pastilles (31ₛᵤₚ, 31_{inf}) sont agencées en matrice.

4. Ensemble de circuit électronique selon l'une quelconque des revendications précédentes, dans lequel lesdites faces extérieures opposées du boîtier (S1ₛᵤₚ, S1_{inf}) sont sensiblement parallèles entre elles.

5. Ensemble de circuit électronique selon l'une quelconque des revendications précédentes, dans lequel les pastilles (31ₛᵤₚ, 31_{inf}) sont conçues pour la soudure par boule.

6. Ensemble de circuit électronique selon l'une quelconque des revendications précédentes, comprenant en outre au moins un élément thermiquement conducteur (41) s'étendant à partir d'une portion du boîtier (1) proche de la microplaquette (10) jusqu'à au moins une pastille (31ₛᵤₚ, 31_{inf}).

7. Ensemble de circuit électronique selon la revendication 6, dans lequel ledit élément thermiquement conducteur (41) s'étend sensiblement perpendiculairement à la face extérieure du boîtier correspondant à ladite au moins une pastille (31ₛᵤₚ, 31_{inf}).

8. Ensemble de circuit électronique selon l'une quelconque des revendications précédentes, comprenant en outre au moins un composant électronique (51) intégré dans le boîtier (1).

9. Ensemble de circuit électronique selon l'une quelconque des revendications précédentes, dans lequel ladite microplaquette (10) est une microplaquette de mémoire.

10. Ensemble de circuit électronique selon l'une quelconque des revendications précédentes, dans lequel chacune des deux portions de fermeture du boîtier (4, 5) a des bornes électriques agencées sur des faces intérieures respectives desdites portions de fermeture.

11. Dispositif comprenant au moins un ensemble de circuit électronique (A1-A4) selon l'une quelconque des revendications précédentes.

12. Dispositif selon la revendication 11, comprenant plusieurs ensembles de circuit électronique (A1-A4) empilés suivant une direction d'empilement (D) sensiblement perpendiculaire aux faces extérieures opposées de boîtiers respectives desdits ensembles (S1ₛᵤₚ-S4ₛᵤₚ, S1_{inf}-S4_{inf}), dans lequel deux ensembles successifs le long de ladite direction d'empilement sont connectés entre eux via des moyens de liaison (300-303) connectant des groupes respectifs de pastilles desdits ensembles successifs (31ₛᵤₚ-34ₛᵤₚ, 31_{inf}-34_{inf}).

13. Dispositif selon la revendication 12, dans lequel les pastilles respectives connectées de deux ensembles successifs dans la pile (31ₛᵤₚ-32_{inf}) sont en face les unes des autres.

14. Dispositif selon la revendication 13, dans lequel les moyens de liaison (300-303) comprennent des boules de soudure.

15. Procédé de fabrication d'un dispositif électronique comprenant les étapes suivantes :
a- obtention d'un premier ensemble de circuit électronique (A1) selon l'une quelconque des revendications 1 à 10 ;
b- obtention d'un deuxième ensemble de circuit électronique (A0) ayant un groupe respectif de pastilles agencé sur une face extérieure dudit deuxième ensemble en relation de correspondance par symétrie-miroir avec un premier des groupes de pastilles dudit premier ensemble (31_{inf}) ;
c- obtention d'un troisième ensemble de circuit électronique (A2) ayant un groupe respectif de pastilles (32_{inf}) agencé sur une face extérieure dudit troisième ensemble (S2_{inf}) en relation de correspondance par symétrie-miroir avec un deuxième des groupes de pastilles dudit premier ensemble (31ₛᵤₚ) ;
d- connexion dudit deuxième ensemble de circuit électronique (A0) au dit premier ensemble de circuit électronique (A1) en agençant un premier groupe de moyens de liaison (300) entre des pastilles dudit deuxième ensemble et des pastilles dudit premier groupe de pastilles dudit premier ensemble (31_{inf}) ; et
e- connexion dudit troisième ensemble de circuit électronique (A2) au dit premier ensemble de circuit électronique (A1) en agençant un deuxième groupe de moyens de liaison (301) entre des pastilles dudit troisième ensemble et des pastilles dudit deuxième groupe de pastilles dudit premier ensemble (31ₛᵤₚ).

16. Procédé selon la revendication 15, dans lequel les moyens de liaison (300, 301) comprennent des boules de soudure.

17. Procédé selon la revendication 15 ou 16, dans lequel ledit deuxième ensemble de circuit électronique (A0) comprend un élément de base du dispositif.

18. Procédé selon l'une quelconque des revendications 15 à 17, dans lequel ledit troisième ensemble de circuit électronique (A2) est pourvu d'un autre groupe de pastilles (32ₛᵤₚ) opposé à ladite face extérieure dudit troisième ensemble (S2_{inf}) et agencé pour connecter ledit troisième ensemble (A2) à un quatrième ensemble de circuit électronique (A3) ayant un groupe respectif de pastilles (33_{inf}) en relation de correspondance par symétrie-miroir avec ledit autre groupe de pastilles dudit troisième ensemble (32ₛᵤₚ).
